Europäisches Patentamt

European Patent Office

Office européen des brevets

(11) Publication number: **0 304 263**
**A2**

## (12) EUROPEAN PATENT APPLICATION

(21) Application number: **88307567.3**

(22) Date of filing: **15.08.88**

(51) Int. Cl.4: **H 01 L 25/14**

(30) Priority: **17.08.87 US 86140**

(43) Date of publication of application:
**22.02.89 Bulletin 89/08**

(84) Designated Contracting States: **DE FR GB NL SE**

(71) Applicant: **LSI LOGIC CORPORATION**
**1551 McCarthy Boulevard**
**Milpitas, CA 95035 (US)**

(72) Inventor: **Corrigan, Wilfried J.**
**222 Polhemus Avenue**
**Atherton California 94025 (US)**

**Dell'Oca, Conrad J.**
**4150 Abel Avenue**
**Palo Alto California 94306 (US)**

(74) Representative: **Jones, Ian et al**
**POLLAK MERCER & TENCH High Holborn House 52-54**
**High Holborn**
**London WC1V 6RY (GB)**

(54) Semiconductor chip assembly.

(57) An integrated circuit assembly includes a plurality of semiconductor chips (10,12;10,18,20,22;10,24;26,28; 10,100,12;10,12a,12b,12c) which are joined mechanically and electrically. The semiconductor chips are formed by the same or different device technology, and can function as different types of elements or circuits.

FIG. 1a

Bundesdruckerei Berlin

**Description**

# SEMICONDUCTOR CHIP ASSEMBLY

This invention relates to an assembly of stacked semiconductor chips and to a method of forming such an assembly.

In the prior art approach to producing electronic circuits that require more than one semiconductor chip, the semiconductor chips are mounted directly or as packaged parts to a support (e.g., printed circuit board) that contains conductive interconnects and other components. Each semiconductor chip may be made following the same or different device technology, e.g., Bipolar, CMOS, etc. Each chip may have separate applications, such as memory or logic, for example, and may function at high speed or low speed. A different process technology is usually necessary to fabricate these different types of chips. While it is possible to combine different device technologies within the same chip, it generally leads to greater process complexity and cost and to some compromise in performance, such as speed of operation of the device. Thus it becomes desirable to be able to interconnect different device technology chips.

Although IC chips may be closely spaced side-by-side on the PC board, the interconnects and the conductors between the chips and the passive components, such as resistors and capacitors, establish relatively long paths, such that undesirable signal delays are introduced during operation of the complete circuit. These delays limit the performance of the IC chip. This problem becomes more significant as the semiconductor chips are made larger, such as one square centimeter or more for example. Long paths require larger device structures on which the chip to achieve higher drive capability to enable overcoming the delays due to long signal lines. These large structures take up a significant percentage of the chip area. For example, in CMOS gate arrays this percentage can be between 15-45%, thereby reducing the circuit complexity that can be achieved on a chip. In addition, the placement of the chips along a single plane extends the area required for the electronic circuit.

Thus, it would be desirable to have an assembly of multiple chips, which are disposed in a relatively compact area, in which a mixture of functions such as provided by bipolar and MOSFET type technologies are incorporated and in which performance may be improved.

In accordance with this invention, an integrated circuit assembly is formed with at least one mother chip that provides a carrier or support for at least one daughter chip. The chips comprise different or similar technologies and structures, such as bipolar or MOSFET, RAM, logic and other type devices. The daughter chip can be attached to the mother chip in various ways. In one approach the daughter chip is aligned and joined to the mother chip by metallurgical bonding by the use of metal solder bumps that provide both electrical and mechanical attachment. Another approach is to use wire bonding to connect electrically mother and daughter chips. In another embodiment, the daughter chip is selected to function as a passive element having one or more layers of interconnect to serve as bus or ground plane. Very large scale integrated circuit assemblies can be made with savings in space and cost by stacking daughter chips on a mother carrier chip by means of this invention. In a further embodiment of this invention, mother and daughter chips communicate using small output structures essentially the same as used for communication within different parts of a chip. In still another embodiment, the daughter chip extends over the edge of one mother chip and connects from one mother chip to another, or to some other support and/or interconnect structure. In another embodiment, more than one level of daughter chips is stacked above one or more mother chips which are disposed side by side; or to daughter chips. In another embodiment, one or more chips are attached at a side of the chip or aligned in a vertical orientation relative to the mother chip.

The invention thus provides an integrated circuit assembly that embodies different technology functions in a high density compact structure. The invention also provides an integrated circuit assembly that minimizes signal delays and enhances performance of an integrated circuit network during operation.

The invention is further described below, by way of example, with reference to the accompanying drawings, in which:

Figure 1a is a perspective top view of a multiplane chip assembly, made in accordance with the invention;

Figure 1b is a side view of the chip assembly of Fig. 1a;

Figure 2 is a perspective top view of an another embodiment of the invention, illustrating a plurality of daughter chips on a single carrier mother chip;

Figure 3 is a top perspective view of another implementation illustrating a passive daughter chip on a CMOS mother chip;

Figure 4 is an alternative embodiment illustrating a power transistor serving as the carrier mother chip;

Figure 5 is a side view of a chip assembly illustrating a daughter chip wire bonded to a mother chip;

Figure 6 is a side view of an embodiment of this invention depicting a daughter chip extending from a mother chip to a second mother chip or support;

Figure 7 is a side view of an embodiment incorporating several planes of semiconductor chips and multilevel interconnects;

FIGURES 8a and 8b are side views of embodiments having a plurality of semiconductor chips stacked vertically; and

FIGURE 9 is a side view of chips vertically attached to a mother chip.

The drawings are representations of multiplane chip assemblies to aid in the explanation of the invention and are not drawn to scale. Similar reference numerals refer to similar elements throughout the drawings.

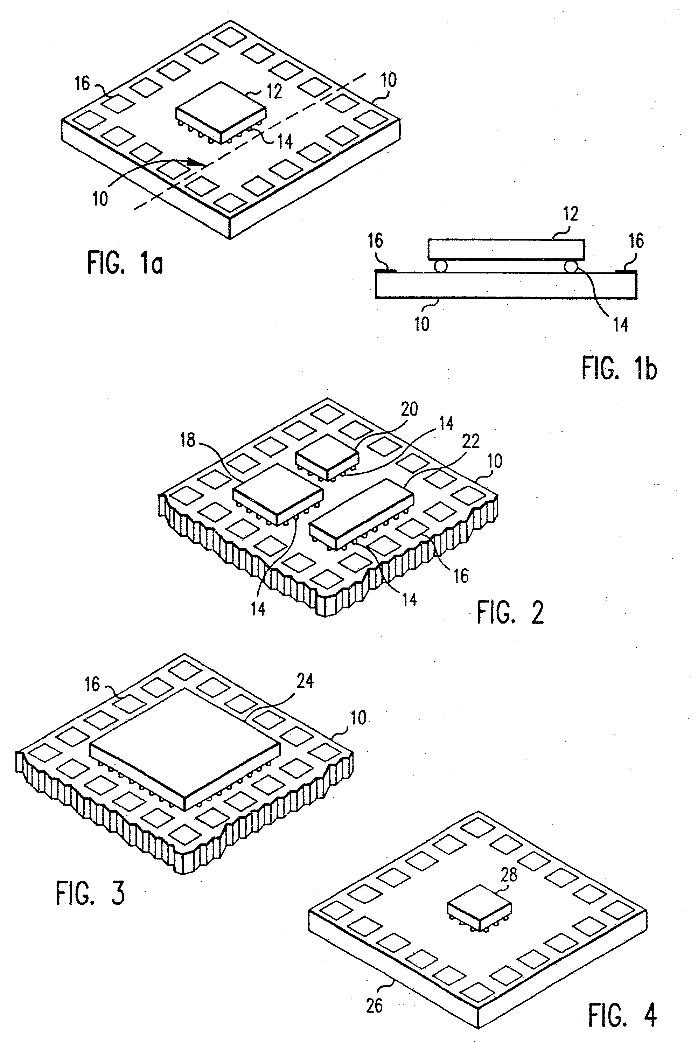

With reference to FIGS. 1a and 1b, a semiconductor chip assembly includes an active mother chip 10, which may be formed as a CMOS (complementary metal oxide semiconductor) logic integrated circuit, and a daughter memory chip 12, which may be any type of chip desired but, for example, might be an E$^2$PROM (electrically erasable read only memory) or an ECL (emitter coupled logic) device. The mother chip, which serves as a carrier or support, and the daughter chip are produced separately by well known conventional processes and technology.

To implement the stacked combination of the two chips, metal or solder bumps 14 are formed on a major surface or face of either the mother chip or the daughter chip or both. The major surface is defined as the surface of the chip on which metallization or electronic circuitry is formed. The bumps are formed on circuit metallization usually referred to as bonding pads (not shown in the figures but similar to and represented by reference numeral 16) by well known methods, such as deposition and etching or by plating the material on the bond pad. The major surfaces or faces of the daughter and mother chips are aligned in registration with the solder bumps and brought into contact. The solder bumps are heated to reflow and upon cooling the daughter and mother chips become attached. The attachment of the two chips can also be effectuated by metallurgical bonding, by way of example. The solder bumps electrically and physically connect the bond pads and the circuitry of the two chips. External electrical connection to the mother chip can be made by wire bonding or by bump and lead frame attachment, etc. If bumps are used they can be formed simultaneously with the bumps used in mother to daughter connection.

In FIG. 2, a plurality of daughter chips 18, 20, 22 are joined to the mother chip 10 by metal bumps 14. In this example, the mother chip serves as a logic chip, whereas the daughter chips may encompass different technologies and function as a DRAM or SRAM (dynamic, or static random access memory), ROM (read only memory), EPROM (erasable programmable read only memory) or E$^2$PROM (electrically erasable PROM) or any other function desired.

An alternative embodiment is shown in FIG. 3, which includes a passive daughter chip 24 which may be used as a bus, ground plane or general interconnect. The daughter chip 24 is joined to the mother chip in the same manner described above.

With reference to FIG. 4, a carrier mother chip is provided that functions as a power transistor 26 and has an integrated circuit chip 28 attached to it by metal bumps or bonds 14.

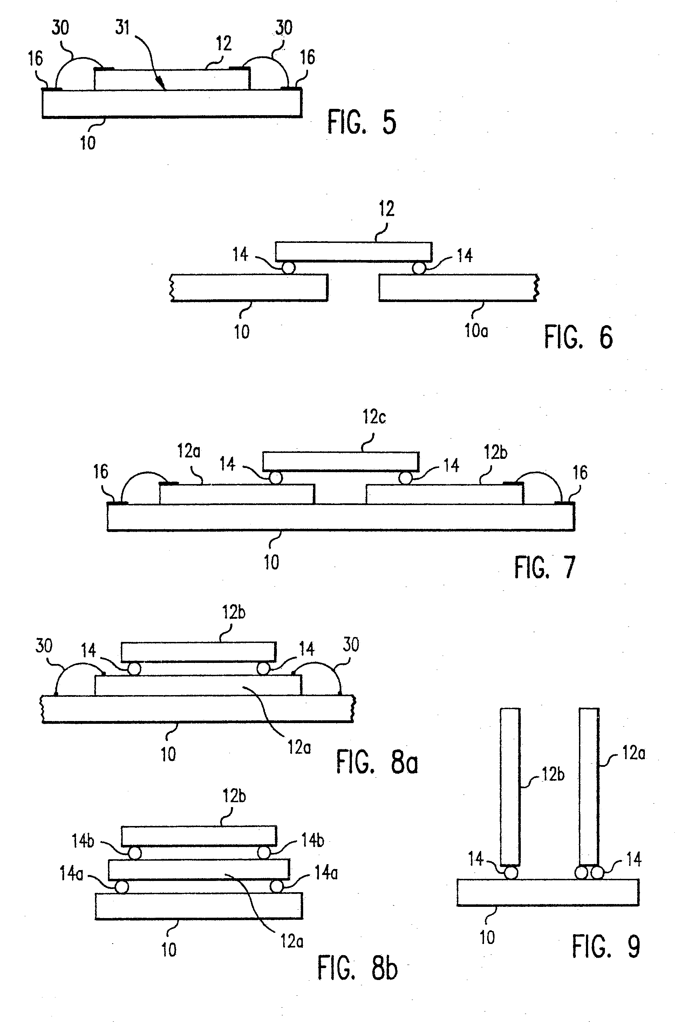

In FIG. 5, a semiconductor chip assembly includes a mother chip 10 and a daughter chip 12 which is attached to the mother chip 10 by an attachment medium 31, which may be an epoxy adhesive, for example. The daughter chip 12 is wire bonded to bond pads 16 by means of wires 30 so that the integrated circuit of the daughter chip 12 is electrically connected to the circuitry of the mother chip 10 through the die bond pads.

FIG. 6 depicts a semiconductor device including a daughter chip 12 with one portion attached to a mother chip 10 by means of one or more solder bumps 14. In this embodiment, the daughter chip 12 projects past one end of the mother chip 10, and has an opposite portion attached to a second mother chip 10a by means of solder bumps 14a so that it straddles the chips 10 and 10a. The metallization lines forming the circuitry of the chip 12 and the chips 10 and 10a are electrically connected. Alternatively, the element 10a can be a support or substrate without an integrated circuit defined therein.

In FIG. 7, the major surface of a bridging chip 12c is attached by solder bumps 14 to spaced chips 12a and 12b. The chips 12a and 12b are disposed in the same plane and are connected respectively to the bond pads 16 of chip 10. The integrated circuitry of chip 12c is formed on its bottom surface and is electrically connected to the circuitry on the top surfaces of chips 12a and 12b and thus electrically coupled to the integrated circuit formed on the top surface of chip 10.

FIGS. 8a and 8b illustrate embodiments having vertical stacks of semiconductor chips, each of which can be formed of a different technology, for example, bipolar, CMOS, RAM or logic devices, and each of which can have different applications or functions. In FIG. 8a, e.g., a first daughter chip 12a is joined to one surface of a mother chip 10 by an attachment medium, and a second daughter chip 12b is joined to the major surface of chip 12a by solder bumps 14. The circuitry of the chip 10 is electrically connected to the circuitry of the chip 12a by bond wires 30, whereas the circuitry of chip 12a is connected to the metallization lines on the major surface of chip 12b by the conductive solder.

Similarly, the assembly of FIG. 8b embodies a stack of chips 10, 12a and 12b, preferably of different technologies, wherein the chips are joined by solder bumps 14a and 14b. The major surface of chip 12a having the integrated circuit formed thereon can be selectively attached to either of the major surfaces of chip 10 or chip 12b on which metallization lines are formed, in which case chip 12a has conductive elements on both the front and back faces with electric connection between front and back. FIG. 9 illustrates a non-parallel attachment of one or more chips to a mother chip. In this case, the bumps 14 are formed on the edge of the chips and attached to the mother chip 10.

By virtue of the novel assembly disclosed herein, it is possible to mix discrete devices with integrated circuits. Conventional technology utilizing metal bumps or metallurgical bonding is used to join and interconnect the semiconductor chips. Memory chips that are manufactured in large volume and at low cost are easily integrated into a custom logic circuit using the approach described herein. Very high speed bipolar memories can be integrated into a logic chip so that signals being processed do not go "off chip" into the memory, which is "on chip".

The proximity of the mother chip and the daughter chip and the use of the low resistance, low capacitance metal bump interconnects preclude the need for additional circuitry that would be necessary to drive the signal along a high resistance, high inductance wire.

It should be understood that there is no intrinsic need for the mother chip to be larger than the daughter chip. The mother chip can be active or inactive, and an inactive mother chip may have two or three layers of metal interconnect. With added two or three layers of metallization on the daughter chips, four to six layers of interconnect at high yields can be realized. With the approach of the stacked chips as opposed to the conventional planar arrangement presently used in the semiconductor industry, the delays encountered for directing a signal around the very long paths of a very large semiconductor chip are reduced so that chip performance is enhanced. By dividing the circuitry into two or more stacked chips, critical paths can be shortened and higher speed performance can be achieved.

It should be understood that the semiconductor chip devices disclosed herein are processed by known conventional methods to provide electrodes and external leads and are packaged in modules or enclosures for connection to external circuitry such as a printed circuit board.

**Claims**

1. An assembly of stacked semiconductor chips comprising:
a mother carrier chip (10;10a;26) having a major surface on which an electronic circuit is formed by a specified semiconductor technology; and
a plurality of daughter chips (12;18,20,22;22;24;28;12a,126,12c) each having a major surface on which an electronic circuit is formed, the major surface being physically and electronically connected to the major surface of the mother carrier chip and supported on the mother carrier chip.

2. An assembly as claimed in claim 1 wherein the function of at least one of the daughter chips complements the function of the mother chip.

3. An assembly as claimed in claim 1 or 2 wherein at least one of the daughter chips is a passive chip for use as a bus, ground plane or interconnect.

4. An assembly as claimed in claim 1, 2 or 3 wherein at least two of the daughter chips are formed with technologies different from each other and from the specified technology of the mother chip so that each chip of the mother and the at least two daughter chips provides a function that differs from any other of the chips.

5. An assembly as claimed in claim 1, 2, 3 or 4 wherein a first daughter chip functions as a programmable read only memory and a second daughter chip functions as a random access memory.

6. An assembly as claimed in any preceding claim wherein at least two of the daughter chips are electrically connected to each other.

7. An assembly as claimed in any preceding claim wherein at least one of the daughter chips is connected to the mother chip by an adhesive (31).

8. An assembly as claimed in any preceding claim wherein at least one of the daughter chips is connected to the mother chip by solder bumps (14).

9. A method for forming a stacked assembly of semiconductor chips, each chip having a major surface on which electronic circuitry is formed, the method comprising the steps of:
attaching with adhesive first and second chips so that the major surface of the chips are disposed in different planes;
wire bonding and electrically interconnecting the electronic circuitry of the first and second chips; and
joining by solder bumps the major faces and electrically interconnecting the electronic circuitry of the second chip and a third chip.

10. A method as claimed in claim 9 including the step of joining and electrically connecting the major surface of said second chip either to the major surface of the first chip or to the major surface of the third chip.

FIG. 1a

FIG. 1b

FIG. 2

FIG. 3

FIG. 4

FIG. 5

FIG. 6

FIG. 7

FIG. 8a

FIG. 8b

FIG. 9